(19) **Europäisches Patentamt**

**European Patent Office**

**Office européen des brevets**

(11) **EP 0 651 899 B1**

(12) **EUROPEAN PATENT SPECIFICATION**

(45) Date of publication and mention
of the grant of the patent:
**28.02.2001 Bulletin 2001/09**

(51) Int Cl.⁷: $G06F\ 17/00$, $H03H\ 21/00$

(86) International application number:
**PCT/US92/05770**

(21) Application number: **92917023.1**

(22) Date of filing: **14.07.1992**

(87) International publication number:
**WO 94/01827 (20.01.1994 Gazette 1994/03)**

(54) **ADAPTIVE CANCELLER FILTER MODULE**

ADAPTIVES LOESCHFILTERMODUL

MODULE DE FILTRE D'ANNULATION ADAPTATIF

(84) Designated Contracting States:
**AT BE CH DE DK ES FR GB GR IT LI LU MC NL SE**

(43) Date of publication of application:
**10.05.1995 Bulletin 1995/19**

(73) Proprietor: **NOISE CANCELLATION TECHNOLOGIES, INC.**
**Linthicum, MD 21090 (US)**

(72) Inventors:
• **ZIEGLER, Eldon W.**
**Linthicum, MD 21090 (US)**
• **FRIEDLANDER, Paul**
**Linthicum, MD 21090 (US)**
• **DENENBERG, Jeffrey N.**
**Linthicum, MD 21090 (US)**

(74) Representative: **Wilhelm & Dauster**
**Patentanwälte European Patent Attorneys**
**Hospitalstrasse 8**
**70174 Stuttgart (DE)**

(56) References cited:
**US-A- 4 939 685**        **US-A- 5 105 377**

EP 0 651 899 B1

**Description**

This invention relates to an adaptive filter module means according to the introductory part of claim 1 and to a method of minimizing the error in an active noise cancellation system according to the introductory part of claim 9.

It is concerned with an LMS filter chip that can be used as a building block in low cost noise cancellation applications.

Prior art adaptive canceller filters have consisted of software code in digital computers, often in digital signal processors (DSP) microprocessors such as the TMS320C25 by Texas Instruments or as discrete hardware components in analog systems. The software - DSP methods lack speed while the analog methods contain an excess of parts and lack adaptability.

INMOS has produced a multiply-accumulate chip, the IMS A100, that can be used to implement digital filters but no method is provided for adaptation of the filter coefficients.

In U.S. Patent No. 5,105,377 an active noise cancellation system applying the Digital Virtual Earth (DVE) algorithm is disclosed. This active cancellation system receives a phenomena input signal representing residual phenomena to be cancelled. It has an adaptive filter in form of a processor of which no explicit architecture is given. This filter outputs a cancellation signal fed to an actuator means for providing active cancellation of noise.

It is the object of this invention to provide a standard adaptive filter module for FIR or IIR filters that can operate at high speed.

Another object is to provide the architecture for a filtered-x adaptive filter module.

A still further object of this invention is to provide an adaptive filter module that will reduce the amount of hardware in active noise cancellation apparatus.

Furthermore, it is an object of this invention to provide a novel filtered-x adaptive filter for enhancing the operation of the digital virtual earth (DVE) algorithm.

These and other objects are achieved by the system of claim 1 and by the method of claim 9. The invention will become apparent when reference is had to the accompanying description and drawings.

The current invention overcomes the prior art limitations while providing a standard adaptive filter module that can operate at high speed, reduces hardware parts count and will lead to reduced cost from volume production.

It works with the Digital Virtual Earth (DVE) algorithm and the AFF algorithm which achieves noise cancellation without requiring either a noise reference or a sync signal as described in U.S. Patent No. 5,105,377. It also works with the Filtered-x class of algorithms which utilize a reference signal and adapt an FIR filter to minimize the power of an error signal.

Fig. 1 is a simplified block diagram of the DVE algorithm,

Fig. 2 is a simplified block diagram of a filtered-x adaptive canceller.

Fig. 3 is a block diagram of the method for measuring the external impulse response.

Fig. 4 shows a block diagram of the module configured so as to have the filter and adapter as a single module.

Fig. 5 is a chart of the system identification and calibration.

Fig. 6 is a diagram of the adaptive canceller filter module, and

Fig. 7 is a diagram of the architecture of the filter chip.

The DVE Algorithm/Filtered-x Algorithm

Description

The Digital Virtual Earth (DVE) algorithm holds the promise of a generic solution to active cancellation without requiring either noise reference or a sync signal. To date it has shown promise in applications which have either a relatively stationary noise signature or a simple noise spectrum.

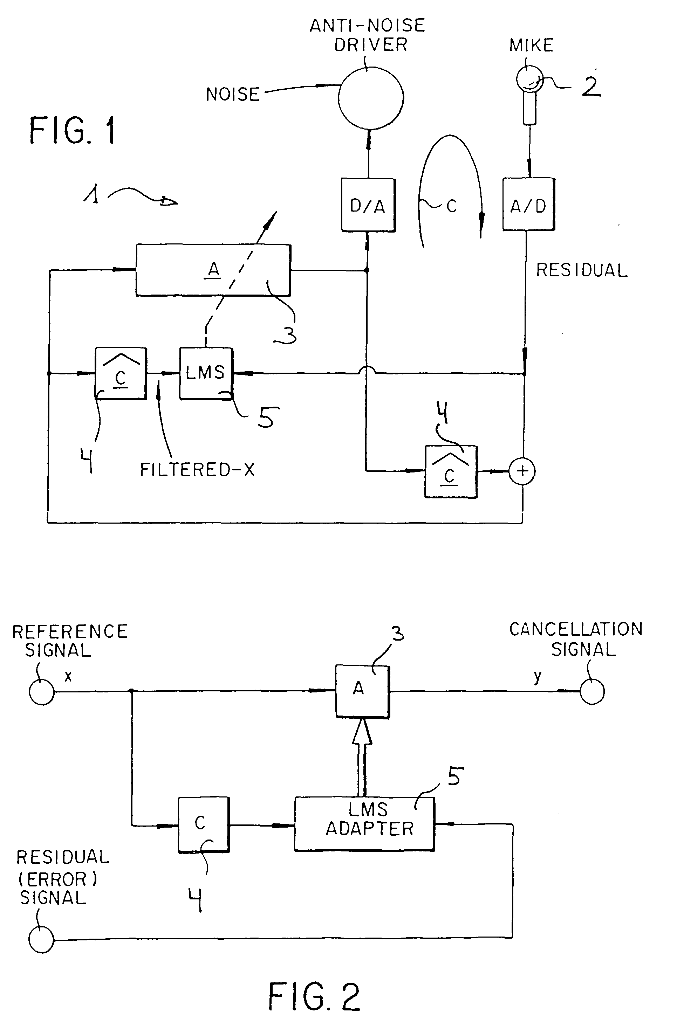

DVE works by first estimating the original noise from the measurement of the residual and knowledge of its anti-noise output as modified by the system transfer function "C". This estimated noise is passed through an adaptive filter to then produce the anti-noise. The Filtered-X LMS adaptation of the filter then minimizes the residual signal power. Fig. 1 shows a simplified block diagram of the DVE algorithm where

"C" - is the system transfer function, that is, the system's effect on the anti-noise as it flows through the D/A (and its reconstruction filter), through the anti-noise driver to the residual microphone, through the A/D (and its anti-aliasing filter).

"$\hat{C}$" - An estimate of "C" established by "calibration" and copies into two physical filters

Filtered - X: This filter makes certain that the LMS updates are done using consistent measures. The reference signal (X - the estimated noise signal) is passed through a copy of "$\hat{C}$" since the

anti-noise signal has gone through the real "C".

Anti-Noise: This filter is used to estimate the actual anti-noise delivered. The anti-noise estimate is then subtracted from the residual to estimate the original noise.

"A" The adaptive equalizer. This filter adapts to minimize the residual signal power.

This system achieves cancellation when the adaptive equalizer, "A", has a transfer function which is the inverse of $C_1$ (the first half of "C", including the D/A, the reconstruction filter, the anti-noise driver and the transit delay to the mike). Since "A" must be causal, this inverse function must cycle slip tonal components to achieve the correct phase.

The highest frequency that can be canceled is determined by the sample rate. Depending on the desired performance, the sampling frequency must be 4 to 6 times the highest frequency to be processed.

The sampling rate and filter length determine the number of filter weights in "A". Since these weights are LMS adapted and their adaptations interact with each other, the more complex the noise, the longer adaptation will take. Noise complexity is a function of:

The number of noise components.

The spacing between noise components (closer spacing - > higher complexity).

The closest spacing of tonal components for which a steady state solution exists is determined by the frequency resolution of the filter which is computed by dividing the sample rate by the filter length. Frequencies that are closer together than this spacing also can be canceled by continuously adapting "A" at the difference frequency between the tones. This is, of course, only possible when the overall noise complexity allows adaptation at a rate consistent with the difference frequency.

### A Non Adaptive DVE (Low Cost Cancellation)

Since the solution DVE finds is a global solution, independent of the specific noise levels, frequencies and phase, there is an opportunity to develop a low cost non-adaptive version of DVE. It is appropriate when the transfer function "C" does not vary (as in open-back headsets) and the minimum noise component spacing is predictable, In this solution calibration becomes a two step operation:

Find "C" - This is a current calibrate procedure. A noise source is synthesized and passed through the external system. The result is correlated with the input to determine the "impulse response". (The frequency domain transform of this impulse response is the transfer function).

Determine "A" - Take the inverse transform of "$C_2$" divided by "C" where "$C_2$" is the known transfer function of the anti-aliasing filter associated with the A/D convener.

### The Motorola 56200

DESCRIPTION

The Motorola 56200 Adaptive Finite Impulse Response (FIR) Filter chip is designated to do most of the processing steps in adaptive feedforward cancellation when there are no delays in the plant. It was developed to cancel echoes in speaker phones and has been applied to other applications as well (e.g. the Toshiba quiet refrigerator). It is capable of processing a 256 tap FIR filter at a sample rate of over 200 KHZ and LMS adapting the filter weights in real time if the sample rate drops to less than 19 KHZ. 56200 chips can be cascaded to provide adaptive filters of almost any length and speed. This is a cost effective means to achieve a high performance DVE system. Its only problem is that since its primary application was "in-wire", there are no provisions in the chip to do Filtered-X.

FILTERED-X

The 56200 passes the reference signal "X" through its 256 sample delay line. These delayed samples (16 bit) are multiplied by the correct weights (24 bit) and accumulated in a 40 bit adder to produce the filter output. The SAME samples are also used to calculate the LMS adaptation of the filter weights leaving no opportunity to use an equalized version of X for robust adaptation. Two solutions to providing for Filtered-X operation have been proposed.

The first solution is to use separate the adaptation calculations from the filter calculations. This straight forward solution has a cost of doubling the data memory requirement but then allows storage of both X and Filtered-X. It can also be done by using separate 56200s for each function and regularly copying the weights from the adaptive chip to the filter chip.

An alternative solution is to add a fixed equalizer at the output of the 56200 (The inverse of C similar to the solution in the low-cost approach). The filter needed for Filtered-X then becomes a fixed delay which can be implemented as an offset register between the weight update calculation times and the filter weight times they change. This has an overall lower cost than the first solution.

Description of the Invention

A widely applicable construct is the filtered-x method illustrated in block diagram form in figure 2. This method consists of a reference signal, called x, which is passed through a filter A, often an FIR or IRR filter, to produce a cancellation signal. The reference signal is further filtered by a filter C, again often an FIR filter, the impulse response of which models the phase characteristics of the external environment of the error path, sometimes referred to as the "plant". The filtering of the reference signal x led to the name "filtered-x". The output of filter C and the error output of the plant are utilized to adapt the coefficients of filter A to minimize a measure of the error, often the average power.

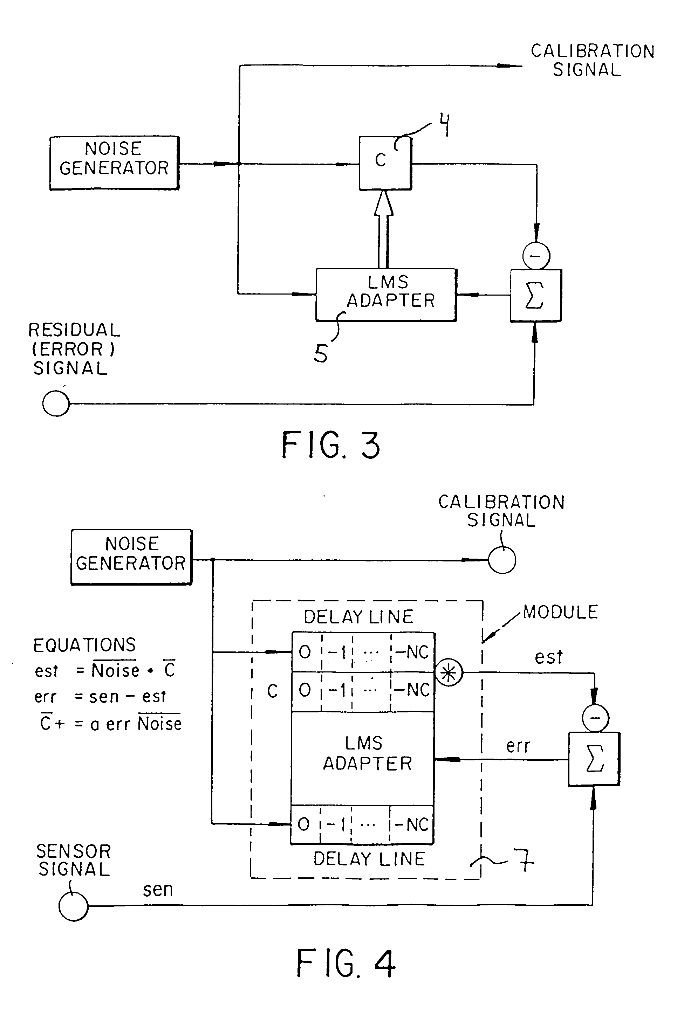

This general technique is used for system identification to measure the external impulse response, filter C, as well as to generate and adapt the cancellation signal. Fig. 3 shows a block diagram of the method for measuring the external impulse response.

In the current invention the convolution performed by filter C and the adapter are integrated in a single module. This basic module can have wide applicability to adaptive filters and active cancellation, thus reducing the time to produce new systems and reducing cost from large scale manufacturing. Fig. 4 shows this module as configured in the system, identification operation of Fig. 3.

The invention consists of a first delay line, DL1; a vector of filter coefficients, C; an adaptor and a second delay line, DL 2. The invention operates at discrete time steps. During each step the following operations take place:

  1. The contents of the first delay line are shifted one place,
  2. The current input to the first delay line is placed in the initial position in delay line,
  3. The current values of the filter coefficients are convolved with the first delay line producing an output value $y_k$ at step k according to

$$y_k = \sum_n DL1_n C_n$$

  where

  $DL1_n$   is the n'th entry in the delay line DL1,
  $C_n$   is the n'th coefficient in C and
  n   ranges over the number of entries in the delay line DLI and the coefficients in C.

  4. The contents of the second delay line are shifted one place,
  5. The current input to the second delay line is placed in the initial position in the delay line,
  6. The current values of the filter coefficients are adapted according to the adaptation algorithm using the current values of the filter coefficients, the contents of the second delay line and an adaptation rate item $\alpha$ to assure convergence.

In a preferred implementation an LMS algorithm is used for adaptation. The filter coefficients are then adapted according to the following:

$$C_{n,k+1} = C_{n,k} + \alpha\, e_k\, DL2_n$$

where:

  $C_{n,k}$ is the n'th coefficient being adapted at step k,
  $e_k$ is the value of the "error" input to the module at step k,
  $DL2_n$ is the n'th entry in the delay line DL2 and
  $\alpha$ is set for convergence.

In a particularly preferred implementation, a will be stored in a register within the module that can be updated externally.

Alternatively, the first delay line can consist of the partial sums from the convolution rather than the delayed input data, as described by INMOS in the documentation for the IMS A100. The errors introduced by this transformation when the coefficients are not constant tend to be small.

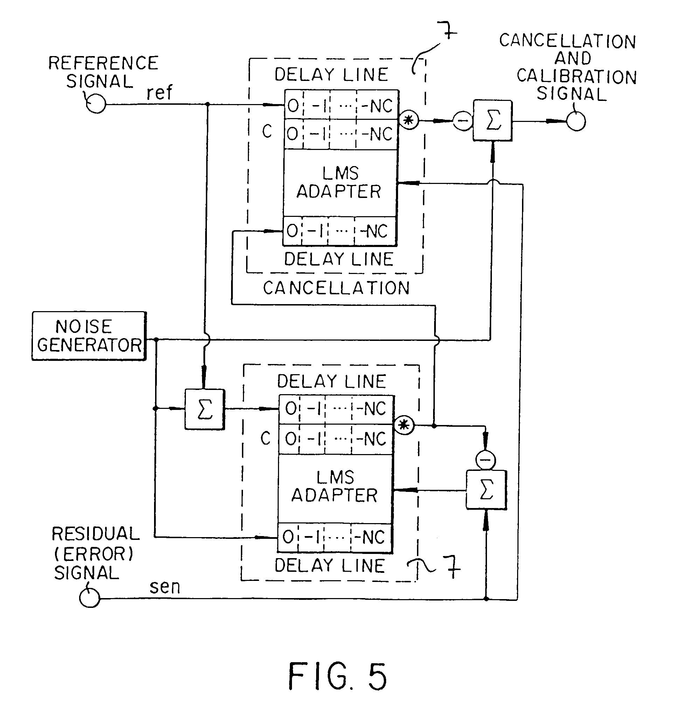

Fig. 5 shows the filtered-x canceller plus the system identification function configured from only two of the invention modules.

In a given manifestation of the invention a length will be selected for the delay lines and number of filter coefficients, such as 32 for example. The invention provides optional cascading of the modules to obtain longer filters when desired. The output of delay lines DL1 and DL2 can be provided to the inputs of the corresponding delay lines in successive modules. Also, cascading can be facilitated by providing a summing input to each module, the value of which is added to the convolution result. In this manner the convolution output of one stage can be added to the convolution output of the next stage to provide the effect of a longer filter.

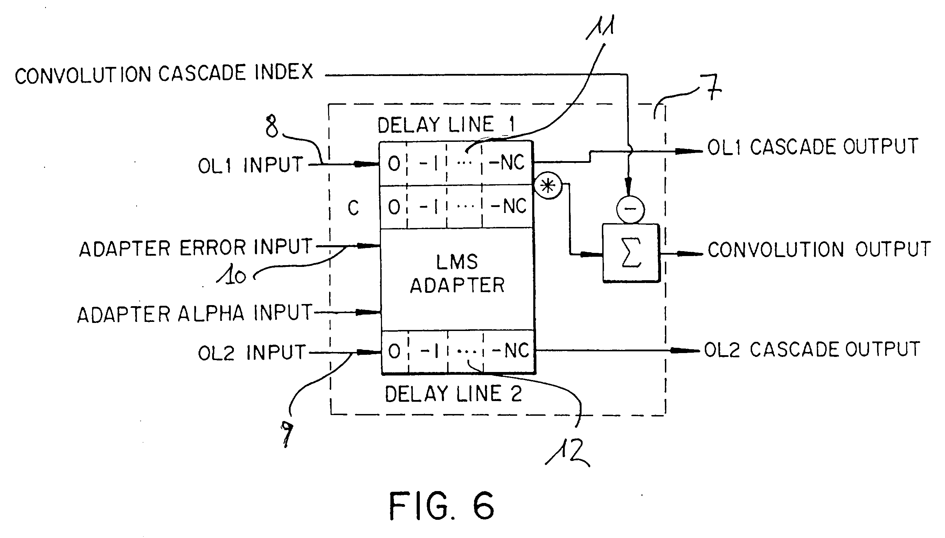

Fig. 6 shows a diagram of the invention including provisions for cascading multiple modules.

There are three independent numerical processes in the Filtered X LMS algorithm described. Specifically,

$$W_{k+1,i} = W_{k,i} + 2\mu\varepsilon X_i^b \qquad \text{Weight Update} \qquad (1)$$

$$y = \sum_{i}^{N} X_i^a W_{N-i} \qquad \text{Convolution} \qquad (2)$$

$$z = \sum_{i}^{N} X_i^b X_i^b \qquad \text{Cross Correlation} \qquad (3)$$

where $X^a$ and $X^b$ are delay line 1 and delay line 2 as described.

As can be seen this can be accomplished with only adders and multipliers. This limits the type of computational resources required to perform this task. To keep the cost reasonable one should reduce the number of the resources while maintaining reasonable throughput. Look at a simple vector pipeline to process a convolution. This can be built with one multiplier, one adder, an accumulator, and two vector register files. We can make use of the parallel nature of this computation by overlapping the multiplications and additions. A time-space diagram of the process shows that both the adder and multiplier are in use at every clock tick except the first where only the multiplier is being used.

| M | 1 | 2 | 3 | 4 | 5 | 6 | ●●● |
|---|---|---|---|---|---|---|---|
| A | | 1 | 2 | 3 | 4 | 5 | 6 | ●●● |

The number in the block is essentially the index $i$ in the summation. As you can see these resources are utilized (almost) 100% of the time. To relate this to throughput we need to find an expression for the number of clock ticks $T_n$ required to calculate a n point convolution. This is easily shown to be:

$$T_n = (n-1) + 2 = n + 1$$

The throughput is simply

$$W = \frac{1}{\tau T_n} = \frac{1}{\tau(n+1)}$$

If the clock cycle $\tau$ is 100nS then the throughput for a 32 tap filter is 303KHZ.

We can now show that we can maintain 100 KHZ throughput for all of the equations without adding any computational resources. We will assume that the cycle time $\tau$ is 100nS and that the expression $2\mu\varepsilon$ is available without any additional processing. A time-space map of the resource utilization to complete one set of the equations (one of the multiples and accumulates for the index *i*) looks like

| M | A | C | B |   |
|---|---|---|---|---|
| A |   | A | C | B |

In this diagram, the A's are the weight updates, the B's are the convolution, and the C's are the cross-correlation. They are arranged in this way because the convolution is dependent on the result of the weight update equation. The cross-correlation calculation is used to fill the gap and maintain the full utilization of the processing resources. Clearly, these operations can be chained as we did for the convolution and the resulting throughput is

$$W = \frac{1}{\tau(3n+1)}$$

and is 101 KHZ for a 32 tap filter.

The problem actually becomes more complicated if the cross-correlation is not calculated.

For this case the time-space diagram is

| M | A |   | B |   |
|---|---|---|---|---|
| A |   | A |   | B |

and there are gaps in the middle. Full utilization can be maintained if delays are introduced between the issue of consecutive instructions, as below

| M | 1 | 2 | 1 | 2 | 3 | 4 | 3 | 4 | 5 |   | ••• |     |
|---|---|---|---|---|---|---|---|---|---|---|-----|-----|
| A |   | 1 | 2 | 1 | 2 | 3 | 4 | 3 | 4 | 5 |     | ••• |

The number indicates the *i*th instruction issued. The second instruction was issued one tick after the first but one must wait three clock ticks before one can issue the third instruction. In this way maximum throughput can be maintained which in this case would be 202 KHZ for a 32 tap filter.

INTERNAL ARCHITECTURE

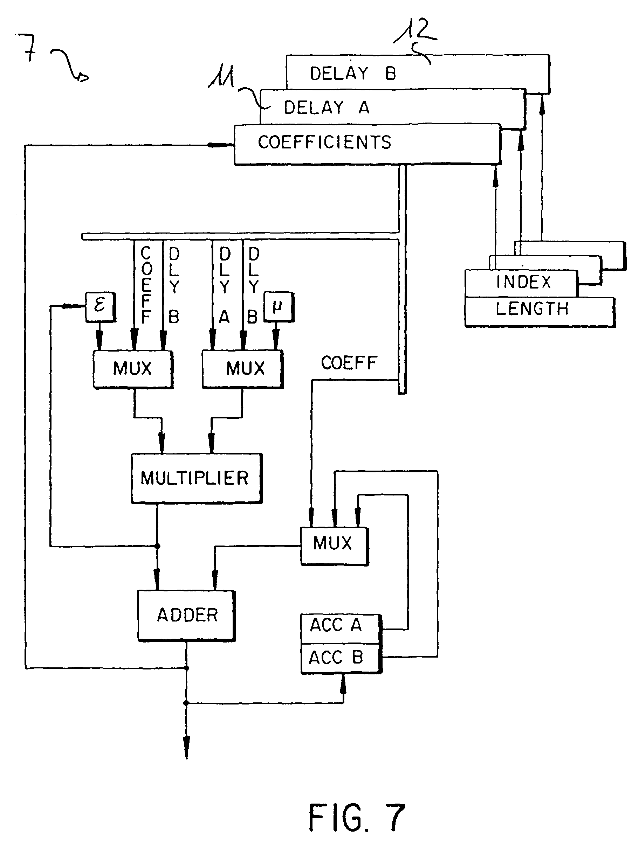

The goal can be accomplished with only one multiplier and one adder. Three vector registers, one to hold the coefficients and the two for the delay lines are also needed. There will be an index register and a length register (one for all three) associated with each vector register to control their access. Two accumulators are necessary to handle the parallel summations of equations 2 and 3. This architecture is shown in Fig. 7 as an FIR filter system.

Note there are also two general purpose registers that are used to hold the values of $\mu$ and $\varepsilon$.

VECTOR REGISTERS

Each vector register is capable of holding a vector of length M. M could be as large as 256 or larger if this is practical for the chip manufacturer. The length of the vector used at run time is controlled by the LENGTH register. This register allows modulo N indexing of the vectors where N is the length of the summation. The actual indexing is performed by an index register associated with each vector.

Each indexing unit will provide the facilities to increment (decrement) the index register. This gives the flexibility required to perform circular convolutions without actually having to shift the data through the vector register. At the beginning of an update cycle (which consists of the weight update, convolution, and cross-correlation) the index registers will point to the oldest values in the delay lines and the coefficient associated with time $\tau=0$. The first step is to write the newest data over the oldest data in the delay lines. Their index registers are then incremented so that what was the N-1th element in the delay line is now the Nth as shown in the figure.

This way the delay lines arc completely dynamic without the need to actually move data.

COMPUTE ENGINE

The compute engine consists of the multiplier and adder plus the supporting elements that allow the computation to take place.

Data is routed from the vector registers to the compute engine on a 72 bit bus or similar bus. This bus simultaneously carries the three 24 bit words of the coefficients and delay lines. The operands to the multiplier are provided from two multiplexers which are connected as shown in the block diagram. Note that in addition to the vector registers the multiplexer can also select two scalar registers $\mu$ and $\varepsilon$. These allow the operations required for the weight update. Initially, $\mu$ is multiplied by the error $\varepsilon$. The results are stored back into $\varepsilon$ for future use. One of the operands for the adder comes from the multiplier. The other comes from a multiplexer and allows for each of the three equations to be performed. Either the weights can be selected to perform the weight update or one of two accumulators to accommodate the two summations.

EXTERNAL ARCHITECTURE

The external architecture of the chip is difficult to specify without the aid of an actual silicone manufacturer. There are a number of operations that must be performed.

- Read the latest value for delay A
- Read the latest value for delay B
- Read the error $\varepsilon$
- Output the result of the convolution
- Output the result of the cross-correlation
- Write/Read the current values of the coefficients
- Cascade the delay lines $X^a$ and $X^b$
- Enable/Disable weight update
- Accept a new value of $\mu$

• Accept a value for the length of the vectors

Clearly the last two can be set up as a standard microprocessor interface. Provision can be made to bootstrap appropriate values. Two pins to select from default lengths and reading a port on power-up are suitable.

Provision is also made so that multiple chips can transfer their coefficients. A chip that is being used for plant identification can broadcast its results to one or two other chips. This can be accomplished with the aid of a microprocessor or independently. In either event the possibility of serial communications should not be overlooked since it saves the cost of many pins.

The first five items on the list can be accomplished in a number of ways. A microprocessor interface is one alternative. Direct communication is another. One interesting possibility is the use of A/D and D/A converters. Sigma-delta technology is becoming more and more common in mixed mode applications. If it is possible to integrate these onto the chip in a cost effective manner then the external interfacing becomes a simple matter of summing and buffering with op-amps.

Changes and modifications will occur to those of ordinary skill in the an without departing from the scope of the following claims.

## Claims

1. An adaptive canceller filter module means (1) for use with filtered-X algorithms in active noise cancellation systems, said module means comprising

   - a first signal sensor means (2) to receive a reference signal,
   - a first filter means (3) adapted to produce a cancellation signal in response to said reference signal,
   - a second filter means (4) adapted to filter the reference signal produced by the first filter means (3), the impulse response of which models at least the phase characteristics of the external environment, and produces an output signal, and
   - second signal sensor means (2) to receive an error signal,
   - adaptive means (5) using the adaptive output signal of said second filter means (4) and said error signal to adapt the coefficients of said first filter means to minimize a measure of the error,

   **charaterized in that**
   said first filter means (3), said second filter means (4) and said adaptive means (5) are formed by an adaptive filter module (7) having

   - a signal input (8) for a signal to be adaptively filtered,
   - a reference signal input (9) and
   - an error input (10),

   said module (7) performing a convolution of the signal input with adaptive filter coefficients, whereby the adaptive filter coefficients are calculated in an adaptation algorithm using reference signal inputs and error inputs and wherein
   the adaptive filter module (7) comprises

   - a first delay line (11) for sequentially storing the signal to be filtered and
   - a second delay line (12) for sequentially storing the reference signal.

2. An adaptive canceller filter module means as in claim 1, wherein a plant error signal generating means is included which is adapted to receive input from a signal sensor means and produce an error signal which is fed to said adaptive means (5).

3. An adaptive canceller filter module means as in claim 1 or 2, wherein a noise generating means is included which is adapted to produce a cancellation signal in conjunction with said first filter means (3).

4. An adaptive canceller filter module means as in one of the preceding claims wherein the second filter means (4) and adaptive means (5) are integrated into a single unit.

5. An adaptive canceller filter module means as in one of the preceding claims wherein the second filter means (4) and the adaptive means (5) consist of one integrated adaptive filter means.

6. An adaptive canceller filter module means as in one of the preceding claims wherein said first filter means (3) is an FIR filter and said second filter means (4) is an FIR filter.

7. An adaptive canceller filter module means as in claim 6 wherein said first filter means (3) has a vector of filter coefficients adapted to be acted upon and changed by the adaptive means output signal.

8. An adaptive canceller filter module means as in claim 7 wherein said filter means (3, 4) comprise an adaptive Finite Impulse Response Filter chip.

9. Method of minimizing the measure of error in an active noise cancellation system using an adaptive filter module (7) having a first (11) and second (12) delay line and further having means for storing a vector of adaptive filter coefficients

characterized by the steps of

- providing a reference signal,
- shifting the contents of the first delay line (11) one place,
- placing the reference signal in the initial position of the first delay line (11),
- convoluting the current values of the adaptive filter coefficients with the content of the first delay line (11) to produce an output value,
- shifting the contents of the second delay line (12) one place,
- placing the current input to the second delay line (12) in the initial position thereof and
- adapting the current values of the filter coefficients according to an adaptation algorithm using the current values of the filter coefficients, the contents of the second delay line and an adaptation rate to assure convergence.

10. A method as in claim 9 wherein convoluting the current values of the filter coefficients is performed according to the formulas

$$(1) \qquad y_k = \sum_n DL1_n C_n$$

or

$$(2) \qquad y_k = \sum_i x_i^9 W_{N-1} \quad .$$

**Patentansprüche**

1. Adaptives Auslöschungsfiltermodulmittel (1) zur Verwendung mit gefiltert-X Algorithmen in aktiven Rauschauslöschungssystemen, wobei die Modulmittel beinhalten:

- ein erstes Signalsensormittel (2), um ein Referenzsignal zu empfangen,
- ein erstes Filtermittel (3), das dafür ausgelegt ist, ein Auslöschungssignal in Reaktion auf das Referenzsignal zu erzeugen,
- ein zweites Filtermittel (4), das dafür ausgelegt ist, das durch das erste Filtermittel (3) erzeugte Referenzsignal zu filtern, wobei die Impulsantwort desselben wenigstens die Phasencharakteristik der externen Umgebung modelliert und ein Ausgangssignal erzeugt, und
- ein zweites Signalsensormittel (2), um ein Fehlersignal zu empfangen,
- adaptive Mittel (5), die das adaptive Ausgangssignal des zweiten Filtermittels (4) und das Fehlersignal dazu verwenden, die Koeffizienten des ersten Filtermittels anzupassen, um ein Fehlermaß zu minimieren,

dadurch gekennzeichnet, dass

das erste Filtermittel (3), das zweite Filtermittel (4) und das adaptive Mittel (5) durch ein adaptives Filtermodul (7) gebildet sind, das aufweist:

- einen Signaleingang (8) für ein Signal, das adaptiv zu filtern ist,
- einen Referenzsignaleingang (9) sowie
- einen Fehlereingang (10),

wobei das Modul (7) eine Faltung des Signaleingangs mit adaptiven Filterkoeffizienten durchführt, für welche die adaptiven Filterkoeffizienten in einem Adaptionsalgorithmus unter Verwendung von Referenzsignaleingängen und Fehlereingängen berechnet werden, und wobei das adaptive Filtermodul (7) beinhaltet:

- eine erste Verzögerungsleitung (11) zum sequentiellen Speichern des zu filternden Signals und
- eine zweite Verzögerungsleitung (12) zum sequentiellen Speichern des Referenzsignals.

2. Adaptives Auslöschungsfiltermodulmittel nach Anspruch 1, wobei ein Anlagefehlersignalerzeugungsmittel enthalten ist, das dafür ausgelegt ist, ein Eingangssignal von einem Signalsensormittel zu empfangen und ein Fehlersignal zu erzeugen, das dem adaptiven Mittel (5) zugeführt wird.

3. Adaptives Auslöschungsfiltermodulmittel nach Anspruch 1 oder 2, wobei ein Rauscherzeugungsmittel enthalten ist, das dafür ausgelegt ist, in Verbindung mit dem ersten Filtermittel (3) ein Löschsignal zu erzeugen.

4. Adaptives Auslöschungsfiltermodulmittel nach einem der vorhergehenden Ansprüche, wobei das zweite Filtermittel (4) und adaptive Filtermittel (5) in eine einzige Einheit integriert sind.

5. Adaptives Auslöschungsfiltermodulmittel nach einem der vorhergehenden Ansprüche, wobei das zweite Filtermittel (4) und das adaptive Mittel (5) aus einem integrierten adaptiven Filtermittel bestehen.

6. Adaptives Auslöschungsfiltermodulmittel nach einem der vorhergehenden Ansprüche, wobei das erste Filtermittel (3) ein FIR-Filter ist und das zweite Filtermittel (4) ein FIR-Filter ist.

7. Adaptives Auslöschungsfiltermodulmittel nach Anspruch 6, wobei das erste Filtermittel (3) einen Vektor von Filterkoeffizienten aufweist, die dafür ausgelegt sind, durch das Ausgangssignal des adaptiven Mittels beeinflusst und geändert zu werden.

8. Adaptives Auslöschungsfiltermodulmittel nach Anspruch 7, wobei die Filtermittel (3, 4) einen adaptiven Filterchip mit endlicher Impulsantwort beinhalten.

9. Verfahren zur Minimierung des Fehlermaßes in einem aktiven Rauschauslöschungssystem, das ein adaptives Filtermodul (7) mit einer ersten (11) und einer zweiten (12) Verzögerungsleitung verwendet und des weiteren Mittel zum Speichern eines Vektors von adaptiven Filterkoeffizienten aufweist,
gekennzeichnet durch die Schritte:

- Bereitstellen eines Referenzsignals,
- Verschieben der Inhalte der ersten Verzögerungsleitung (11) um einen Platz,
- Platzierung des Referenzsignals in der Anfangsposition der ersten Verzögerungsleitung (11),
- Falten der Momentanwerte der adaptiven Filterkoeffizienten mit dem Inhalt der ersten Verzögerungsleitung (11), um einen Ausgabewert zu erzeugen,
- Verschieben der Inhalte der zweiten Verzögerungsleitung (12) um einen Platz,
- Platzieren des momentanen Eingabesignals auf der zweiten Verzögerungsleitung (12) in der Anfangsposition derselben und
- Anpassen der Momentanwerte der Filterkoeffizienten gemäß einem Adaptionsalgorithmus unter Verwendung der Momentanwerte der Filterkoeffizienten, der Inhalte der zweiten Verzögerungsleitung und einer Adaptionsrate, um Konvergenz sicherzustellen.

10. Verfahren nach Anspruch 9, wobei die Faltung der Momentanwerte der Filterkoeffizienten gemäß den folgenden Formeln durchgeführt wird:

$$(1) \quad y_k = \sum_n DLl_nC_n$$

oder

$$(2) \quad y_k = \sum_i x_i{}^9 W_{N-1} \quad .$$

## Revendications

**1.** Moyen de module de filtre de dispositif d'annulation adaptatif (1) destiné à une utilisation avec des algorithmes à X filtré dans des systèmes actifs d'annulation de bruit, ledit moyen de module comprenant

- un premier moyen de capteur de signal (2) afin de recevoir un signal de référence,
- un premier moyen de filtre (3) conçu pour produire un signal d'annulation en réponse audit signal de référence,
- un second moyen de filtre (4) conçu pour filtrer le signal de référence produit par le premier moyen de filtre (3), dont la réponse impulsionnelle modélise au moins les caractéristiques de phase de l'environnement externe, et produit un signal de sortie, et
- un second moyen de capteur de signal (2) afin de recevoir un signal d'erreur,
- un moyen adaptatif (5) utilisant le signal de sortie adaptatif dudit second moyen de filtre (4) et ledit signal d'erreur en vue d'adapter les coefficients dudit premier moyen de filtre afin de minimiser une mesure de l'erreur,

caractérisé en ce que
ledit premier moyen de filtre (3), ledit second moyen de filtre (4) et ledit moyen adaptatif (5) sont formés par un module de filtre adaptatif (7) comportant

- une entrée de signal (8) destinée à un signal devant être filtré de façon adaptative,
- une entrée de signal de référence (9) et
- une entrée d'erreur (10),

ledit module (7) exécutant une convolution de l'entrée du signal avec des coefficients de filtres adaptatifs, d'où il résulte que les coefficients de filtres adaptatifs sont calculés dans un algorithme d'adaptation en utilisant des entrées du signal de référence et des entrées d'erreur, et dans lequel
le module de filtre adaptatif (7) comprend

- une première ligne à retard (11) destinée à mémoriser séquentiellement le signal devant être filtré et
- une seconde ligne à retard (12) destinée à mémoriser séquentiellement le signal de référence.

**2.** Moyen de module de filtre de dispositif d'annulation adaptatif selon la revendication 1, dans lequel un moyen de génération de signal d'erreur de l'équipement est compris, lequel est conçu pour recevoir une entrée provenant d'un moyen de capteur de signal et produire un signal d'erreur qui est appliqué audit moyen adaptatif (5).

**3.** Moyen de module de filtre de dispositif d'annulation adaptatif selon la revendication 1 ou 2, dans lequel un moyen de génération de bruit est compris, lequel est conçu pour produire un signal d'annulation conjointement audit premier moyen de filtre (3).

**4.** Moyen de module de filtre de dispositif d'annulation adaptatif selon l'une des revendications précédentes dans lequel le second moyen de filtre (4) et le moyen adaptatif (5) sont intégrés en une seule unité.

**5.** Moyen de module de filtre de dispositif d'annulation adaptatif selon l'une des revendications précédentes dans lequel le second moyen de filtre (4) et le moyen adaptatif (5) sont constitués d'un moyen de filtre adaptatif intégré.

**6.** Moyen de module de filtre de dispositif d'annulation adaptatif selon l'une des revendications précédentes dans lequel ledit premier moyen de filtre (3) est un filtre à réponse impulsionnelle finie (FIR) et ledit second moyen de filtre (4) est un filtre à réponse impulsionnelle finie (FIR).

**7.** Moyen de module de filtre de dispositif d'annulation adaptatif selon la revendication 6 dans lequel ledit premier moyen de filtre (3) comporte un vecteur de coefficients de filtre conçu pour être traité par le signal de sortie du moyen adaptatif et être modifié par celui-ci.

**8.** Moyen de module de filtre de dispositif d'annulation adaptatif selon la revendication 7 dans lequel ledit moyen de filtre (3, 4) comprend un circuit intégré de filtre à réponse impulsionnelle finie adaptatif.

**9.** Procédé de minimisation de la mesure d'erreur dans un système actif d'annulation de bruit utilisant un module de filtre adaptatif (7) comprenant une première (11) et une seconde (12) lignes à retard et comportant en outre un moyen destiné à mémoriser un vecteur de coefficients de filtre adaptatif
caractérisé par les étapes consistant à

- fournir un signal de référence,
- décaler le contenu de la première ligne à retard (11) d'un emplacement,
- placer le signal de référence à la position initiale de la première ligne à retard (11),
- réaliser une convolution des valeurs en cours des coefficients de filtres adaptatifs avec le contenu de la première ligne à retard (11) en vue de produire une valeur de sortie,
- décaler le contenu de la seconde ligne à retard (12) d'un emplacement,
- placer l'entrée en cours vers la seconde ligne à retard (12) à la position initiale de celle-ci et
- adapter les valeurs en cours des coefficients de filtres conformément à un algorithme d'adaptation en utilisant les valeurs en cours des coefficients de filtres, le contenu de la seconde ligne à retard et un taux d'adaptation en vue d'assurer une convergence.

**10.** Procédé selon la revendication 9 dans lequel la convolution des valeurs en cours des coefficients de filtres est exécutée conformément aux formules

$$(1) \quad y_k = \sum_n DL1_n C_n$$

ou

$$(2) \quad y_k = \sum_i x_i^9 W_{N-i}$$

FIG. 1

ANTI-NOISE
DRIVER

MIKE

NOISE

2

1

D/A

C

A/D

A

3

RESIDUAL

C

LMS

5

FILTERED-X

4

4

C

+

FIG. 2

REFERENCE
SIGNAL

3

CANCELLATION
SIGNAL

x

A

y

C

LMS
ADAPTER

5

RESIDUAL
(ERROR)
SIGNAL

4

FIG. 2

FIG. 3

EQUATIONS

$\text{est} = \overline{\text{Noise}} \cdot \overline{C}$

$\text{err} = \text{sen} - \text{est}$

$\overline{C}+ = a \, \text{err} \, \overline{\text{Noise}}$

FIG. 4

FIG. 5

FIG. 6

EP 0 651 899 B1

FIG. 7